# EUROPEAN PATENT APPLICATION

(11) **EP 4 668 339 A1**
(43) Date of publication of application: **24.12.2025**
(21) Application number: 23930006.4
(22) Date of filing: 28.11.2023
(51) Int. Cl.: H01L 29/47, H01L 29/45, H01L 29/78, H01L 29/739, H01L 29/872

(54) **FIELD EFFECT TRANSISTOR, INSULATED GATE BIPOLAR TRANSISTOR AND TRENCH MOS-TYPE DIODE**

(30) Priority: 29.03.2023 CN 202310325051
(71) Applicant: Guangzhou Huarui Shengyang Investment Co., Ltd., Guangzhou, Guangdong 510663 (CN)
(72) Inventor: XUE, Yong, Guangzhou, Guangdong 510663 (CN); YIN, Xiangyang, Guangzhou, Guangdong 510663 (CN); LIU, Wei, Guangzhou, Guangdong 510663 (CN); DENG, Yun, Guangzhou, Guangdong 510663 (CN); HUANG, Wenlong, Guangzhou, Guangdong 510663 (CN); TANG, Bin, Guangzhou, Guangdong 510663 (CN)
(74) Representative: Lorenz Seidler Gossel Part. mbB
(86) International application number: PCT/CN2023/134665
(87) International publication number: WO 2024/198439

(57) **Abstract**

This disclosure relates to the technical field of semiconductors. Through localized design optimization of the structure of existing Schottky-junction MOSFETs, the disclosure proposes a novel field-effect transistor possessing both large on-state current capability and normally-off functionality. The field-effect transistor disclosed herein comprises: an n-type semiconductor layer; a drain electrode; a source electrode; a gate electrode; and a gate insulating film. A Schottky barrier exists between a first portion of the source electrode and the n-type semiconductor layer, while a second portion of the source electrode contacts the n-type semiconductor layer forming an Ohmic contact. The on-state current capability of the field-effect transistor of the disclosure matches or even exceeds that of a pn-junction MOSFET under equivalent conditions.

## Description

This application claims the priority of the China patent application filed with the China Patent Office on March 29, 2023, with application number 202310325051.0 and invention title "Field-Effect Transistor, Insulated Gate Bipolar Transistor, and Trench MOS-Type Diode", all contents of which are incorporated by reference in this application.

### TECHNICAL FIELD

This disclosure relates to the technical field of semiconductors, and particularly relates to a field-effect transistor, an insulated gate bipolar transistor, and a trench MOS-type diode.

### BACKGROUND ART

The Schottky source-drain MOSFET structure was proposed in the 1960s. It utilizes metal source and drain to replace the semiconductor doped source and drain of traditional pn-junction MOSFETs, and a Schottky contact barrier is formed between the metal source/drain and the semiconductor. For a Schottky source-drain MOSFET, when a positive voltage is applied between the source and drain, the Schottky barrier formed between the source electrode and the semiconductor material is reverse-biased, widening the depletion layer to achieve turn-off. Accordingly, the Schottky source-drain MOSFET is a normally-off device. The turn-on of the Schottky source-drain MOSFET occurs under the action of a positive gate bias voltage, forming a conductive channel, where carriers from the source end directly tunnel through the barrier into the channel.

Compared to traditional pn-junction MOSFETs, Schottky source-drain MOSFETs have the following advantages: First, the metal Schottky contact is ultra-shallow, effectively suppressing the short-channel effect and source-drain punch-through that plague conventional MOSFETs when device dimensions are significantly reduced, providing the possibility for further miniaturization of MOSFETs. Second, the high conductivity of the metal-semiconductor contact can further reduce source-drain resistance. Third, in Schottky source-drain MOSFETs, there is no parasitic bipolar transistor effect, resulting in faster response speed and suitability for higher frequencies. Fourth, ion implantation is not required to form n+ or p+ source/drain regions, eliminating the need for high-temperature annealing, simplifying the process. This also avoids lattice damage caused by ion implantation and annealing, helping to achieve high interface quality, thereby obtaining high-quality dielectric layers, with improved withstand voltage and reliability.

However, since its inception, Schottky source-drain MOSFETs have had two significant drawbacks: First, small on-state current. When the source-drain voltage V_{DS}>0 of a Schottky source-drain MOSFET, the Schottky contact barrier formed between the Schottky source electrode and the semiconductor is reverse-biased, widening the depletion layer. This prevents the formation of a complete and high-concentration electron conduction channel between the drain and Schottky source electrodes even when a positive gate-source voltage V_{GS} is applied between the gate electrode and Schottky source electrode. A certain Schottky barrier height always exists in the region near the Schottky source electrode. This limited Schottky barrier height suppresses electron carrier transport, allowing only a small fraction of electron carriers to form current through the tunneling effect. According to the conductivity formula σ=nqu (where n is the concentration of electron carriers participating in conduction, q is the electron charge, and u is the mobility under a certain carrier concentration), the lower the carrier concentration participating in conduction, the lower the conductivity. Further, according to the current density J=σE (where E represents the electric field strength), the lower the conductivity σ, the lower the current density J. This is why the on-state current of a Schottky source-drain MOSFET is smaller than that of a pn-junction MOSFET under the same conditions. The on-state current of a conventional pn-junction MOSFET can reach tens to hundreds of amperes, while that of a Schottky source-drain MOSFET under the same conditions can only reach milliampere levels or even lower. Second, large off-state leakage current, which includes thermionic emission current from the source end through substrate transmission and tunneling current from the source end.

These two drawbacks, especially the small on-state current, have not been well resolved to this day, severely restricting the use of Schottky source-drain MOSFETs, so much so that commercial applications of Schottky source-drain MOSFETs are still unseen.

### SUMMARY OF THE INVENTION

In view of this, aiming at the problems existing in existing Schottky source-drain MOSFETs, the disclosure improves the structure of existing Schottky source-drain MOSFETs, solves the problem of small on-state current in existing Schottky source-drain MOSFETs, and provides a normally-off semiconductor device with large on-state current capability.

To solve the above technical problem, the disclosure provides a field-effect transistor, comprising:
An n-type semiconductor layer;
Electrodes including a drain electrode, a source electrode, and a gate electrode;
A gate insulating film interposed between the gate electrode and the n-type semiconductor layer;
A Schottky barrier exists between a first portion of the source electrode and the n-type semiconductor layer, a second portion of the source electrode contacts the n-type semiconductor layer forming an Ohmic contact; and the second portion of the source electrode is closer to the gate insulating film than the first portion of the source electrode.

Preferably, the first portion of the source electrode contacts the n-type semiconductor layer forming a Schottky barrier.

Preferably, a dielectric layer is provided between the first portion of the source electrode and the n-type semiconductor layer, and the first portion of the source electrode, the dielectric layer, and the n-type semiconductor layer form an MIS (Metal-Insulator-Semiconductor) junction.

Preferably, the second portion of the source electrode is located between the first portion of the source electrode and the gate insulating film.

Preferably, the work function of the material corresponding to the second portion of the source electrode is not higher than the work function of the material corresponding to the n-type semiconductor layer.

Preferably, the width from an end of the second portion of the source electrode away from the gate insulating film to the gate insulating film ranges between 3nm and 200nm.

Preferably, the width from an end of the second portion of the source electrode away from the gate insulating film to the gate insulating film ranges between 3nm and 100nm.

Preferably, the second portion of the source electrode and the first portion of the source electrode are metals or alloys having different work functions.

Preferably, the first portion and the second portion of the source electrode are coplanar, or the bottom surface of the first portion of the source electrode is lower than the bottom surface of the second portion of the source electrode.

Preferably, the n-type semiconductor layer comprises multiple semiconductor layers, and the donor concentrations of each semiconductor layer are different.

Preferably, the donor concentration in the region of the n-type semiconductor layer contacting the second portion of the source electrode to form the Ohmic contact is ≥ 1.0×10¹⁸ cm⁻³.

Preferably, the region of the n-type semiconductor layer contacting the first portion of the source electrode to form the Schottky contact has a trench, the inner wall of the trench is covered with an insulating film layer, the trench is filled with a conductive material, and the conductive material is separated from the n-type semiconductor layer by the insulating film layer.

Preferably, the region of the n-type semiconductor layer contacting the first portion of the source electrode to form the Schottky contact has a plurality of mutually spaced p-type regions formed by ion implantation, and the p-type regions and the n-type semiconductor layer form pn junctions.

Preferably, the field-effect transistor is a lateral MOSFET or a vertical MOSFET, wherein the vertical MOSFET is one of a vertical planar-gate MOSFET, a vertical trench-gate MOSFET, a vertical shielded-gate MOSFET, or a vertical super-junction MOSFET.

Preferably, the n-type semiconductor layer is made of an oxide semiconductor, a compound semiconductor, or an elemental semiconductor.

To solve the above problems, the disclosure further provides a field-effect transistor, comprising:
A semiconductor layer comprising an n-type conductive region and a high-resistance doped region;
Electrodes including a drain electrode, a source electrode, and a gate electrode;
A gate insulating film interposed between the gate electrode and the n-type semiconductor layer;
A Schottky barrier exists between a first portion of the source electrode and the n-type conductive region of the semiconductor layer, a second portion of the source electrode contacts the high-resistance doped region of the semiconductor layer; and the second portion of the source electrode is closer to the gate insulating film than the first portion of the source electrode.

Preferably, the first portion of the source electrode contacts the n-type conductive region of the semiconductor layer forming a Schottky barrier.

Preferably, a dielectric layer is provided between the first portion of the source electrode and the n-type conductive region of the semiconductor layer, and the first portion of the source electrode, the dielectric layer, and the n-type conductive region of the semiconductor layer form an MIS (Metal-Insulator-Semiconductor) junction.

Preferably, the second portion of the source electrode is located between the first portion of the source electrode and the gate insulating film.

Preferably, the work function of the material corresponding to the second portion of the source electrode is not higher than the work function of the material corresponding to the semiconductor layer.

Preferably, the second portion of the source electrode and the first portion of the source electrode are metals or alloys having different work functions.

Preferably, the field-effect transistor is a lateral MOSFET or a vertical MOSFET, wherein the vertical MOSFET is one of a vertical planar-gate MOSFET, a vertical trench-gate MOSFET, a vertical shielded-gate MOSFET, or a vertical super-junction MOSFET.

Regarding the above inventive content, the disclosure has the following beneficial effects:
1. The disclosure improves the structure of existing Schottky source-drain MOSFETs by adjusting the pure Schottky source electrode in Schottky source-drain MOSFETs to a combination of an Ohmic source electrode and a Schottky source electrode, wherein the Ohmic source electrode is interposed between the gate insulating film and the Schottky source electrode. Through this structural detail improvement, the field-effect transistor of the disclosure can form a complete and high-concentration electron conduction channel between the drain electrode and the source electrode under the action of a positive gate bias voltage. At this time, when a forward voltage is applied between the drain electrode and the source electrode, current flows between the drain and source electrodes. The on-state current capability of the field-effect transistor of the disclosure can match or even exceed that of a pn-junction MOSFET under the same conditions, thereby completely solving the problem of small on-state current in existing Schottky source-drain MOSFETs, significantly improving its current-carrying capability, and meeting application scenarios requiring ampere-level currents and above.
2. The field-effect transistor of the disclosure, while solving the problem of small on-state current in existing Schottky source-drain MOSFETs, remains a normally-off device. The field-effect transistor of the disclosure can achieve normally-off functionality through the combined depletion effect on electron carriers by the MIS junction formed between the gate electrode-gate insulating film layer-n-type semiconductor layer and the Schottky junction formed by the source electrode and the n-type semiconductor layer.
3. The field-effect transistor of the disclosure, while solving the problem of small on-state current in existing Schottky source-drain MOSFETs, can still maintain the original advantages of Schottky source-drain MOSFETs (detailed in the background section).
4. The field-effect transistor of the disclosure has a simple process and high feasibility for mass production, facilitating product commercialization.
5. The field-effect transistor of the disclosure can be widely applied to various semiconductor materials, including oxide semiconductor materials, and can be fabricated to have large on-state current and low leakage without the need for p-type materials.

The disclosure further provides a field-effect transistor, comprising:
A p-type semiconductor layer;
Electrodes including a drain electrode, a source electrode, and a gate electrode;
A gate insulating film interposed between the gate electrode and the p-type semiconductor layer;
A Schottky barrier exists between a first portion of the source electrode and the p-type semiconductor layer, a second portion of the source electrode contacts the p-type semiconductor layer forming an Ohmic contact; the second portion of the source electrode is closer to the gate insulating film than the first portion of the source electrode.

Preferably, the first portion of the source electrode directly contacts the p-type semiconductor layer forming a Schottky barrier.

Preferably, a dielectric layer is provided between the first portion of the source electrode and the p-type semiconductor layer, and the first portion of the source electrode, the dielectric layer, and the p-type semiconductor layer form an MIS (Metal-Insulator-Semiconductor) junction.

The disclosure has the following beneficial effects:
p-type semiconductors and Schottky source-drain electrodes can also constitute Schottky source MOSFETs. Due to the existence of the Schottky barrier, such Schottky source MOSFETs also suffer from the problem of small on-state current. By applying the structural innovation of the disclosure, adjusting the pure Schottky source electrode to a combination of an Ohmic source electrode and a Schottky source electrode, with the Ohmic source electrode interposed between the gate insulating film and the Schottky source electrode, through this change in structural detail, the problem of small on-state current in Schottky source-drain MOSFETs constituted by p-type semiconductors and Schottky source-drain electrodes can also be solved, improving their current-carrying capability.

The disclosure further provides an insulated gate bipolar transistor (IGBT), comprising:
A semiconductor layer including a p-type conductive semiconductor layer and an n-type semiconductor layer stacked on the p-type conductive semiconductor layer;
Electrodes including a collector electrode, an emitter electrode, and a gate electrode;
A gate insulating film interposed between the gate electrode and the n-type semiconductor layer;
A Schottky barrier exists between a first portion of the emitter electrode and the n-type semiconductor layer,
A second portion of the emitter electrode contacts the n-type semiconductor layer forming an Ohmic contact; and the second portion of the emitter electrode is closer to the gate insulating film than the first portion of the emitter electrode.

Preferably, the second portion of the emitter electrode is located between the first portion of the emitter electrode and the gate insulating film.

Preferably, the first portion of the emitter electrode contacts the n-type semiconductor layer forming a Schottky barrier contact.

The disclosure further provides a trench MOS-type diode, comprising:
A semiconductor layer including a first n-type semiconductor layer and a second n-type semiconductor layer, the second n-type semiconductor layer being stacked on the first n-type semiconductor layer, the second n-type semiconductor layer having a trench, the trench opening from a surface of the second n-type semiconductor layer opposite to the first n-type semiconductor layer, and a donor concentration of the second n-type semiconductor being less than a donor concentration of the first n-type semiconductor;
An anode electrode formed on the surface of the second n-type semiconductor layer opposite to the first n-type semiconductor layer;
A cathode electrode formed on a surface of the first n-type semiconductor layer opposite to the second n-type semiconductor layer;
A trench MOS gate electrode buried within the trench of the second n-type semiconductor layer, separated from the semiconductor layer by a gate insulating film;
A first portion of the anode electrode contacts the second n-type semiconductor layer forming a Schottky contact, a second portion of the anode electrode contacts the second n-type semiconductor layer forming an Ohmic contact, and the second portion of the anode electrode is closer to the gate insulating film than the first portion of the anode electrode.

Preferably, the work function of the material corresponding to the second portion of the anode electrode is lower than the work function of the material corresponding to the second n-type semiconductor layer.

Preferably, the width from an end of the second portion of the anode electrode away from the insulating film to the insulating film ranges between 3nm and 200nm, preferably 3nm to 150nm.

Preferably, the trench MOS gate electrode directly contacts the anode electrode, or an insulating layer is interposed between the trench MOS gate electrode and the anode electrode.

The disclosure has the following beneficial effects:
The trench MOS-type diode of the disclosure, compared to traditional trench MOS-type Schottky diodes, adjusts the pure Schottky anode to a combination of an Ohmic anode (second portion of the anode electrode) and a Schottky anode (first portion of the anode electrode). Through this structural detail change, when the trench MOS-type diode of the disclosure is forward conducting, since there is no Schottky barrier between the Ohmic anode and the second n-type semiconductor layer, only a very small voltage is needed to turn it on. Therefore, the trench MOS-type diode of the disclosure can further reduce the turn-on voltage, thereby reducing the on-state resistance.

### DESCRIPTION OF THE DRAWINGS

To describe the technical solutions of the disclosure more clearly, the following will briefly introduce the drawings required for describing the embodiments or the prior art. Obviously, some drawings in the following description are merely illustrative of some embodiments of the disclosure. The scope of protection claimed by the disclosure is not limited to the embodiments. For those of ordinary skill in the art, other drawings can be obtained based on these drawings without creative effort.
FIG. 1 is a vertical cross-sectional view of an embodiment of an existing pn-junction vertical trench-gate MOSFET.
FIG. 2 is a vertical cross-sectional view of an embodiment of an existing Schottky-junction vertical trench-gate MOSFET.
FIG. 3a is a structural modeling schematic diagram for part of an existing pn-junction MOSFET structure and part of an existing Schottky-junction MOSFET structure.
FIG. 3b is a structural modeling schematic diagram for part of an existing pn-junction MOSFET structure and part of a MOSFET structure based on the disclosure.
FIG. 4 is a vertical cross-sectional view of an embodiment of an existing Schottky-junction vertical planar-gate MOSFET.
FIG. 5a is a vertical cross-sectional view of a first embodiment of a vertical planar-gate MOSFET according to an embodiment of the disclosure.
FIG. 5b is a vertical cross-sectional view of a second embodiment of a vertical planar-gate MOSFET according to an embodiment of the disclosure.
FIG. 6a is a vertical cross-sectional view of a first embodiment of a vertical trench-gate MOSFET according to an embodiment of the disclosure.
FIG. 6b is a vertical cross-sectional view of a second embodiment of a vertical trench-gate MOSFET according to an embodiment of the disclosure.
FIG. 6c is a vertical cross-sectional view of a third embodiment of a vertical trench-gate MOSFET according to an embodiment of the disclosure.
FIG. 6d is a vertical cross-sectional view of a fourth embodiment of a vertical trench-gate MOSFET according to an embodiment of the disclosure.
FIG. 6e is a vertical cross-sectional view of a fifth embodiment of a vertical trench-gate MOSFET according to an embodiment of the disclosure.
FIG. 7a is a vertical cross-sectional view of a first embodiment of a vertical shielded-gate MOSFET according to an embodiment of the disclosure.
FIG. 7b is a vertical cross-sectional view of a second embodiment of a vertical shielded-gate MOSFET according to an embodiment of the disclosure.
FIG. 7c is a vertical cross-sectional view of a third embodiment of a vertical shielded-gate MOSFET according to an embodiment of the disclosure.
FIG. 7d is a vertical cross-sectional view of a fourth embodiment of a vertical shielded-gate MOSFET according to an embodiment of the disclosure.
FIG. 7e is a vertical cross-sectional view of a fifth embodiment of a vertical shielded-gate MOSFET according to an embodiment of the disclosure.
FIG. 7f is a vertical cross-sectional view of a sixth embodiment of a vertical shielded-gate MOSFET according to an embodiment of the disclosure.
FIG. 8a is a vertical cross-sectional view of a first embodiment of a vertical super-junction MOSFET according to an embodiment of the disclosure.
FIG. 8b is a vertical cross-sectional view of a second embodiment of a vertical super-junction MOSFET according to an embodiment of the disclosure.
FIG. 9 is a vertical cross-sectional view of an embodiment of an insulated gate bipolar transistor according to an embodiment of the disclosure.
FIG. 10 is a vertical cross-sectional view of an embodiment of a trench MOS-type diode according to an embodiment of the disclosure.
FIG. 11 is a vertical cross-sectional view of an embodiment of a vertical trench-gate MOSFET related to a p-type semiconductor layer according to an embodiment of the disclosure.

The technical features corresponding to the labels in the drawings are:
11: Drain electrode (Collector)
12: Source electrode (Emitter)
12a: Ohmic source electrode (Ohmic emitter)
12b: Schottky source electrode (Schottky emitter)
13: Gate electrode
21a: n-type semiconductor layer
21b: n-type semiconductor layer
31a: p-type semiconductor layer
31b: p-type semiconductor layer
41: High-resistance type semiconductor region
51: Gate insulating film
52: Insulating film layer
61: Cathode electrode
62: Anode electrode
62a: Ohmic anode (second portion of anode electrode)
62b: Schottky anode (first portion of anode electrode)
63: Trench MOS gate electrode

### SPECIFIC EMBODIMENTS

In the following description, specific details such as specific system structures and technologies are proposed for illustration rather than limitation, in order to provide a thorough understanding of the embodiments of the disclosure. However, it should be clear to those skilled in the art that the disclosure can also be implemented in other embodiments without these specific details. In other instances, detailed descriptions of well-known systems, devices, and methods are omitted to avoid unnecessary details obscuring the description of the disclosure.

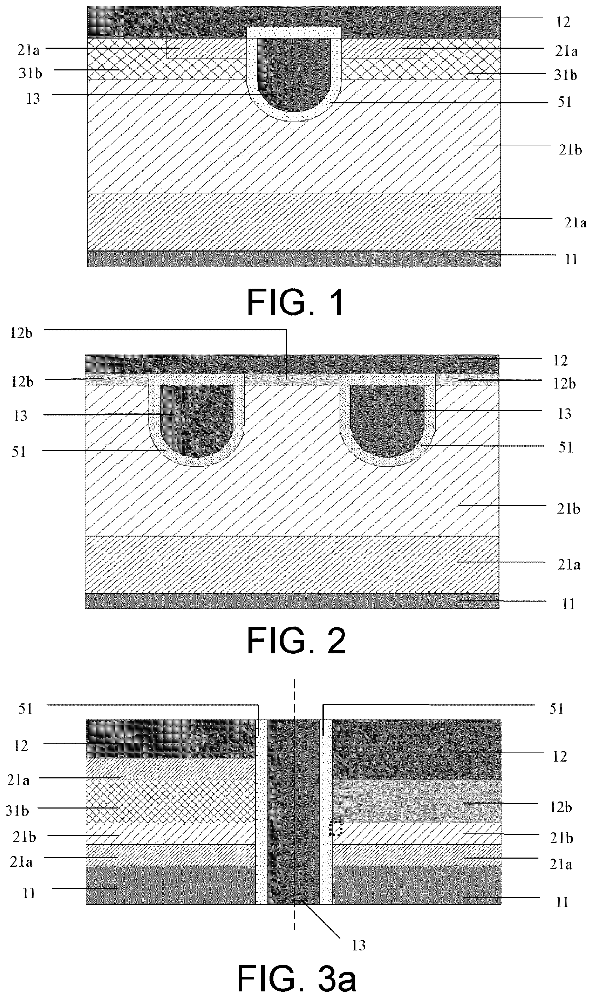

FIG. 1 is a vertical cross-sectional view of an embodiment of an existing pn-junction vertical trench-gate MOSFET. The pn-junction vertical trench-gate MOSFET (hereinafter referred to as pn-junction MOSFET) has, from bottom to top: drain electrode 11, n-type semiconductor layer 21a, n-type semiconductor layer 21b, p-type semiconductor layer 31b, n-type semiconductor layer 21a, a trench embedded from the upper surface of n-type semiconductor layer 21a downward into n-type semiconductor layer 21a, p-type semiconductor layer 31b, and n- type semiconductor layer 21b, a gate electrode 13 located in the trench and surrounded by gate insulating film 51, and source electrode 12.

For the pn-junction MOSFET shown in FIG. 1, due to the existence of the internal pn junction, when only a forward voltage is applied between drain electrode 11 and source electrode 12, the pn junction located within the MOSFET body is reverse-biased, widening the depletion region, preventing the formation of a complete electron conduction channel between drain electrode 11 and source electrode 12, and no current flows between drain and source. Based on this principle, the pn-junction MOSFET shown in FIG. 1 is a normally-off device. When a voltage V_{GS}>V_{GS(th)} (the gate-source voltage when the channel just forms) is applied to gate electrode 13, an n-type thin layer (inversion layer) containing only electron carriers is formed in the region of p- type semiconductor layer 31b near gate insulating film 51. This n-type thin layer connects the electron conduction channel between drain electrode 11 and source electrode 12. At this time, when a positive voltage is applied between drain electrode 11 and source electrode 12, current flows between drain and source, and the MOSFET turns on.

FIG. 2 is a vertical cross-sectional view of an embodiment of an existing Schottky-junction vertical trench-gate MOSFET. This MOSFET has, from bottom to top: drain electrode 11, n-type semiconductor layer 21a, n-type semiconductor layer 21b, a trench located in n- type semiconductor layer 21b, gate electrode 13 located in the trench and wrapped by gate insulating film 51, Schottky source electrode 12b forming a Schottky barrier contact with n- type semiconductor layer 21b, and source electrode 12 located thereon.

For the Schottky-junction MOSFET shown in FIG. 2, due to the existence of the Schottky barrier formed between Schottky source electrode 12b and n-type semiconductor layer 21b, when only a forward voltage is applied between drain electrode 11 and source electrode 12, the Schottky junction is reverse-biased, widening the depletion region, preventing the formation of a complete electron conduction channel between drain electrode 11 and source electrode 12, and no current flows between drain and source. Based on this principle, the Schottky-junction MOSFET shown in FIG. 2 is a normally-off device.

When a positive voltage is applied between gate electrode 13 and source electrode 12, due to the existence of the Schottky barrier between Schottky source electrode 12b and n- type semiconductor layer 21b, a complete and high-concentration electron conduction channel cannot be formed between drain electrode 11 and source electrode 12. At this time, even when a positive voltage is applied between drain electrode 11 and source electrode 12, the depletion layer widened by the reverse bias of the Schottky barrier formed between Schottky source electrode 12b and n-type semiconductor layer 21b suppresses the transport of electron carriers. As a result, only a small fraction of electron carriers forms current between drain and source through the tunneling effect, leading to very poor on-state current capability of existing Schottky-junction MOSFETs. Its on-state current is much smaller than that of a pn-junction MOSFET under the same conditions.

To more clearly show the difference in on-state current between existing pn-junction MOSFETs and existing Schottky-junction MOSFETs, parts of the traditional pn-junction MOSFET structure and the traditional Schottky-junction MOSFET structure are extracted, and quantified using semiconductor process and device simulation software (TCAD).

FIG. 3a is a modeling schematic diagram for part of an existing pn-junction MOSFET structure and part of an existing Schottky-junction MOSFET structure.

In the modeling schematic shown in FIG. 3a, the area in the center is gate electrode 13. On both sides of the gate electrode 13 are gate insulating films 51. The stacked structure on the left half is equivalent to part of a pn-junction MOSFET structure, which has, from bottom to top: drain electrode 11, n-type semiconductor layer 21a, n-type semiconductor layer 21b, p-type semiconductor layer 31b, n-type semiconductor layer 21a, source electrode 12. The stacked structure on the right half is equivalent to part of a Schottky-junction MOSFET structure, which has, from bottom to top: drain electrode 11, n-type semiconductor layer 21a, n-type semiconductor layer 21b, Schottky source electrode 12b, source electrode 12.

In the actual simulation, the semiconductor layer material was set to SiC, the concentration of n-type semiconductor layer 21a was set to 5×10¹⁸ cm⁻³, the concentration of n-type semiconductor layer 21b was set to 1×10¹⁷ cm⁻³, the concentration of p- type semiconductor layer 31b was set to 1×10¹⁷ cm⁻³, the material of the gate insulating film was set to HfO₂, the thickness of the gate insulating film was set to 50 nm, and the material of Schottky source electrode 12b was set to metal W (work function ≈4.55 eV), forming a Schottky contact with n- type semiconductor layer 21b.

In the modeling schematic shown in FIG. 3a, when the voltage V_{GS} between gate electrode 13 and source electrode 12 is set to 0V, for the part of the pn-junction MOSFET structure on the left half, a space charge region is formed in the pn junction area formed by p- type semiconductor layer 31b and n- type semiconductor layer 21b, with an influence range of approximately 250 nm. A space charge region is also formed at the MIS (Metal-Insulator-Semiconductor) junction constituted by gate electrode 13, gate insulating film 51, and n- type semiconductor layer 21b on the left side, with an influence range of approximately 100 nm. For the part of the Schottky-junction MOSFET structure on the right half, a space charge region is formed in the Schottky junction area formed by Schottky source electrode 12b and n- type semiconductor layer 21b, with an influence range of approximately 101nm. A space charge region is also formed at the MIS (Metal-Insulator-Semiconductor) junction constituted by gate electrode 13, gate insulating film 51 (dielectric layer), and n-type semiconductor layer 21b on the right side, with an influence range of approximately 100nm.

In the modeling schematic shown in FIG. 3a, when the voltage V_{GS} between gate electrode 13 and source electrode 12 is set to 10V, for the part of the pn-junction MOSFET structure on the left half, a complete electron conduction channel is formed in the region of the semiconductor layer between drain electrode 11 and source electrode 12 near gate insulating film 51. In this entire conduction channel, the widths of regions with electron concentration >1.5× 10¹⁸ cm⁻³ are: 3nm in p-type semiconductor layer 31b, 6.25nm in n- type semiconductor layer 21b, and 3 nm to 6.25 nm in the pn junction depletion region formed by p-type semiconductor layer 31b and n-type semiconductor layer 21b. The pn-junction MOSFET has a complete and high-concentration electron conduction channel between drain and source. At this time, when a positive voltage is applied between drain and source, the pn-junction MOSFET can conduct.

In the modeling schematic shown in FIG. 3a, when the voltage V_{GS} between gate electrode 13 and source electrode 12 is set to 10V, for the part of the Schottky-junction MOSFET structure on the right half, a complete and high-concentration electron conduction channel is not formed in the region of n- type semiconductor layer 21b between drain electrode 11 and Schottky source electrode 12b near gate insulating film 51. A high-concentration electron conduction channel is formed in the region of n- type semiconductor layer 21b near gate insulating film 51 more than 10 nm below Schottky source electrode 12b (below the dashed box). However, in the region of n- type semiconductor layer 21b near gate insulating film 51 within 0-10 nm below Schottky source electrode 12b (encompassed by the dashed box), due to the existence of the Schottky barrier formed between Schottky source electrode 12b and n- type semiconductor layer 21b, within this 0-10 nm range, the electron concentration drops from the 10¹⁸ cm⁻³ level to the 10²⁰ cm⁻³ level, failing to form a high-concentration electron conduction channel. This results in the failure to form a complete and high-concentration electron conduction channel between drain electrode 11 and source electrode 12 even under the action of a positive bias applied to the gate electrode. This causes only a small fraction of electron carriers to form current through the tunneling effect, resulting in a very low concentration of electron carriers participating in conduction. According to the conductivity σ= nqu (where n is the concentration of electron carriers participating in conduction, q is the electron charge, u is the mobility under a certain carrier concentration), the lower the carrier concentration participating in conduction, the lower the conductivity σ. Further, according to the current density J =σE (where E represents the electric field strength), the lower the conductivity σ, the lower the current density J (on-state current is positively correlated with current density). This is the reason why the on-state current of a Schottky source MOSFET is smaller than that of a pn-junction MOSFET under the same conditions.

Based on the analysis of FIG. 3a, it is precisely due to the existence of the Schottky barrier between the source electrode and the n-type semiconductor layer that the on-state current of the Schottky source MOSFET is very low.

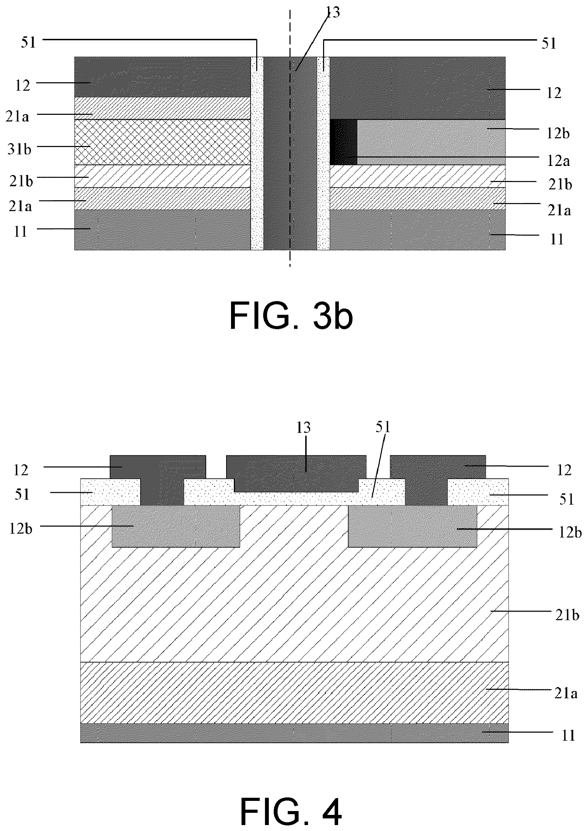

The concept of the disclosure is to improve the source electrode of the Schottky source MOSFET, so that a Schottky barrier still exists between the first portion of the source electrode and the n-type semiconductor layer, the second portion of the source electrode forms an Ohmic contact with the n-type semiconductor layer, and the second portion of the source electrode is interposed between the first portion of the source electrode and the gate insulating film. Based on this concept, the disclosure performed modeling and simulation using semiconductor process and device simulation software (TCAD). The following explains in detail with reference to the modeling schematic shown in FIG. 3b. FIG. 3b is a modeling schematic diagram for part of a traditional pn-junction MOSFET structure and part of a MOSFET structure based on the disclosure.

The difference between the modeling structure of FIG. 3b and that of FIG. 3a is that the portion of Schottky source electrode 12b near gate insulating film 51 is changed to Ohmic source electrode 12a. The width of Ohmic source electrode 12a can be set between 3 nm and 200nm. In this structure, the width of Ohmic source electrode 12a is set to 80nm, and Ohmic source electrode 12a is set to form an Ohmic contact with n- type semiconductor layer 21b.

In the modeling schematic shown in FIG. 3b, for the part of the MOSFET structure based on the disclosure on the right half, when the voltage V_{GS} between gate electrode 13 and source electrode 12 is set to 10V, a complete and high-concentration electron conduction channel is formed in the region of n- type semiconductor layer 21b between drain electrode 11 and Schottky source electrode 12b near gate insulating film 51. Compared to the situation at V_{GS}=10V in the modeling simulation of FIG. 3a, in FIG. 3b, in the region near gate insulating film 51 on the right side of n- type semiconductor layer 21b, within the electron conduction channel between drain and source, the electron carrier concentration is in the range of 10¹⁷ to 10¹⁹ cm⁻³. Compared to the existing Schottky-junction MOSFET shown in FIG. 3a (electron concentration drops sharply from the 10¹⁸ cm⁻³ level to the 10²⁰ cm⁻³ level), the increase in electron carrier concentration in the MOSFET of the disclosure is very significant. This is quite comparable to the electron carrier concentration in the electron conduction channel of a pn-junction MOSFET under the same conditions. According to the conductivity σ = nqµ, when the carrier concentration n participating in conduction is greatly increased, the conductivity will increase significantly. According to the current density J = σE (where E represents the electric field strength), when the conductivity σ increases significantly, the current density J increases significantly. Based on this, it can be seen that after structural optimization based on the solution of the disclosure, the current-carrying capability of the existing Schottky-junction MOSFET can be greatly improved to match that of a pn-junction MOSFET under the same area. The MOSFET based on the solution of the disclosure can completely solve the problem of small on-state current in existing Schottky-junction MOSFETs.

In the modeling schematic shown in FIG. 3b, while solving the problem of small on-state current in existing Schottky-junction MOSFETs, the MOSFET based on the solution of the disclosure also has an off function. Under reasonable design of the width of Ohmic source electrode 12a, the depletion effect on electron carriers in n-type semiconductor layer 21b by the MIS junction formed by gate electrode 13 (on its left), gate insulating film 51, and n-type semiconductor layer 21b, and the depletion effect on electron carriers in n-type semiconductor layer 21b by Schottky source electrode 12b (on its right), under the combined action of these two depletions, the MOSFET of the disclosure can achieve normally-off functionality. In the modeling schematic shown in FIG. 3b, when the set width range of the Ohmic source electrode is between 3nm and 120nm, the MOSFET based on the solution of the disclosure can achieve normally-off.

FIG. 4 is a vertical cross-sectional view of an embodiment of an existing Schottky-junction vertical planar-gate MOSFET. This MOSFET has, from bottom to top: drain electrode 11, n-type semiconductor layer 21a, n- type semiconductor layer 21b, a trench located in n- type semiconductor layer 21b, Schottky source electrode 12b located in the trench, source electrode 12 connected thereto, gate insulating film 51, and gate electrode 13 located thereon.

For the Schottky-junction MOSFET shown in FIG. 4, due to the existence of the Schottky barrier formed between Schottky source electrode 12b and n-type semiconductor layer 21b, a complete and high-concentration electron conduction channel cannot be formed even when a positive voltage is applied between gate electrode 13 and source electrode 12. At this time, when a positive voltage is applied between drain electrode 11 and source electrode 12, the reverse bias of the Schottky barrier continues to widen the depletion region, allowing only a small fraction of electron carriers to form a very small on-state current through the tunneling effect.

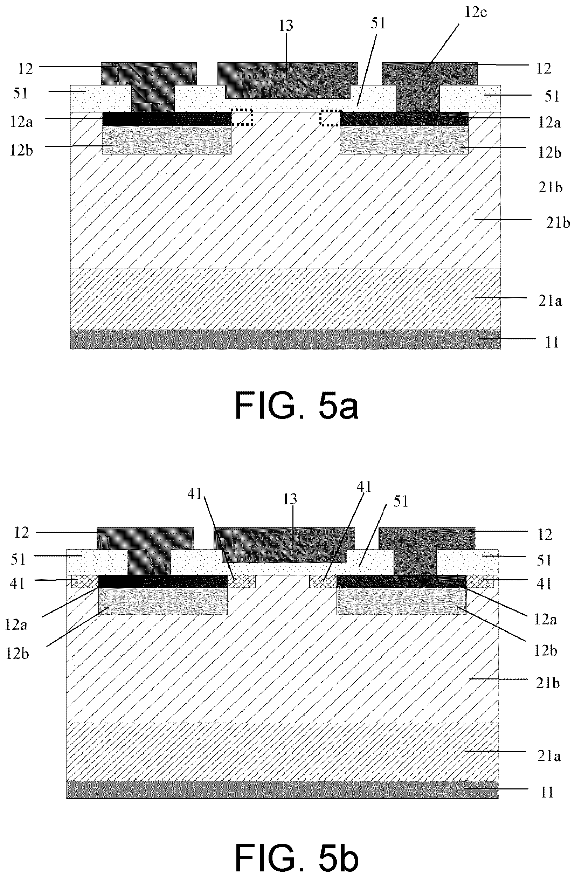

FIG. 5a is a vertical cross-sectional view of a first embodiment of a vertical planar-gate MOSFET according to an embodiment of the disclosure. The vertical planar-gate MOSFET has, from bottom to top: drain electrode 11, n-type semiconductor layer 21a, n- type semiconductor layer 21b, a trench located in n-type semiconductor layer 21b, source electrode 12, gate insulating film 51, and gate electrode 13 located thereon. Source electrode 12 includes a first portion 12b, a second portion 12a, and a third portion 12c. The first portion 12b of the source electrode contacts n-type semiconductor layer 21b forming a Schottky barrier contact, defined as Schottky source electrode 12b. The second portion 12a of the source electrode contacts n-type semiconductor layer 21b forming an Ohmic contact, defined as Ohmic source electrode 12a. Schottky source electrode 12b and Ohmic source electrode 12a are located in the trench, with Ohmic source electrode 12a located on the upper surface of Schottky source electrode 12b, and Ohmic source electrode 12a located between Schottky source electrode 12b and gate insulating film 51. Ohmic source electrode 12a is connected to the third portion 12c of source electrode 12.

In this embodiment, the work function of the material corresponding to Ohmic source electrode 12a is lower than the work functions of the materials corresponding to n-type semiconductor layer 21b and n-type semiconductor layer 21a. The width from the end of Ohmic source electrode 12a away from gate insulating film 51 to gate insulating film 51 ranges between 3 nm and 200 nm, preferably between 3 nm and 100 nm. Ohmic source electrode 12a and Schottky source electrode 12b are metals or alloys having different work functions. n-type semiconductor layer 21a and n-type semiconductor layer 21b can be made of one material selected from oxide semiconductors, compound semiconductors, or elemental semiconductors. In other experiments, the region of n-type semiconductor layer 21b contacting Schottky source electrode 12b to form the Schottky contact can have a plurality of mutually spaced p-type regions formed by ion implantation, and the p-type regions and the n-type semiconductor layer form pn junctions.

The MOSFET structure shown in FIG. 5a is based on the structure of the existing Schottky-junction MOSFET shown in FIG. 4, with a local change in the nature of the metal contact with n- type semiconductor layer 21b. The pure Schottky contact Schottky source electrode 12b in FIG. 4 is conceptually changed to the combination of Ohmic contact and Schottky contact, Ohmic source electrode 12a and Schottky source electrode 12b in FIG. 5a, with Ohmic source electrode 12a closer to gate insulating film 51 than Schottky source electrode 12b. When the voltage V_{GS} between gate electrode 13 and source electrode 12 exceeds the threshold voltage V_{GS(th)}, a complete and high-concentration electron channel is formed in the region of n- type semiconductor layer 21b below and adjacent to gate insulating film 51. At this time, when a positive voltage is applied between drain electrode 11 and source electrode 12, current will flow between drain and source. When the voltage V_{GS} between gate electrode 13 and source electrode 12 is 0V, due to the combined depletion effect on electron carriers in n-type semiconductor layer 21b by the MIS junction located above and below Ohmic source electrode 12a and the Schottky junction located beside it, the corner region of n-type semiconductor layer 21b that is both adjacent to gate insulating film 51 and simultaneously adjacent to Ohmic source electrode 12a (position circled by the dashed line in FIG. 5a) becomes a depletion region for electron carriers. This depletion region blocks the electron conduction channel between drain electrode 11 and source electrode 12. Therefore, the MOSFET based on the solution of the disclosure is a normally-off device. Thus, the MOSFET based on the solution of the disclosure can be designed as a normally-off device with large on-state current capability.

FIG. 5b is a vertical cross-sectional view of a second embodiment of a vertical planar-gate MOSFET according to an embodiment of the disclosure. The vertical planar-gate MOSFET in this embodiment is based on the MOSFET structure shown in FIG. 5a, with the adjacent region in n- type semiconductor layer 21b contacting Ohmic source electrode 12a designed as a high-resistance type semiconductor region 41; the rest of the structure remains unchanged. When the material of n- type semiconductor layer 21b in FIG. 5b is a material with a bandgap greater than 3 eV, such as zinc oxide, it can be modified by nitrogen doping to form a high-resistance doped region. When the voltage V_{GS} between gate electrode 13 and source electrode 12 is greater than 0V, as V_{GS} increases, besides forming a high-concentration electron accumulation layer in the region of n- type semiconductor layer 21b adjacent to gate insulating film 51, a relatively high-concentration electron accumulation layer also forms in the region of high-resistance type semiconductor layer 41 adjacent to gate insulating film 51. At this time, when a positive voltage is applied between drain electrode 11 and source electrode 12, current will flow between drain and source. When the voltage V_{GS} between gate electrode 13 and source electrode 12 is 0V, this high-resistance doped region design cleverly blocks the conduction channel between drain electrode 11 and source electrode 12. Therefore, the MOSFET based on the solution of the disclosure is a normally-off device. Thus, the MOSFET based on the solution of the disclosure can be designed as a normally-off device with large on-state current capability.

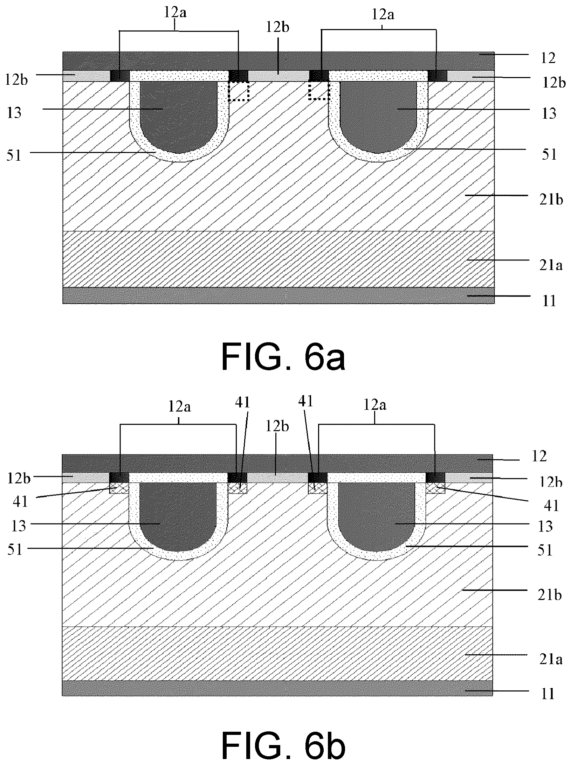

FIG. 6a is a vertical cross-sectional view of a first embodiment of a vertical trench-gate MOSFET according to an embodiment of the disclosure. The vertical trench-gate MOSFET in this embodiment is based on the existing Schottky-junction MOSFET shown in FIG. 2, changing the source electrode 12b that formed a pure Schottky contact with n-type semiconductor layer 21b to Ohmic source electrode 12a and Schottky source electrode 12b. In the MOSFET shown in FIG. 6a, Ohmic source electrode 12a forms an Ohmic contact with n-type semiconductor layer 21b, Schottky source electrode 12b forms a Schottky contact with n-type semiconductor layer 21b, and Ohmic source electrode 12a is closer to gate insulating film 51 than Schottky source electrode 12b.

In the MOSFET shown in FIG. 6a, when the voltage V_{GS} between gate electrode 13 and source electrode 12 exceeds V_{GS(th)}, a complete and high-concentration electron channel is formed in the region of n- type semiconductor layer 21b adjacent to the right side of gate insulating film 51. At this time, when a positive voltage is applied between drain electrode 11 and source electrode 12, current will flow between drain and source. When the voltage V_{GS} between gate electrode 13 and source electrode 12 is 0V, due to the combined depletion effect on electron carriers in n- type semiconductor layer 21b by the MIS junction located on the left and right sides of Ohmic source electrode 12a and the Schottky junction located beside it, the corner region of n-type semiconductor layer 21b that is both adjacent to gate insulating film 51 and simultaneously adjacent to Ohmic source electrode 12a (position circled by the dashed line in FIG. 6a) becomes a depletion region for electron carriers. This depletion region blocks the electron conduction channel between drain electrode 11 and source electrode 12. Therefore, the MOSFET based on the solution of the disclosure is a normally-off device. Thus, the MOSFET based on the solution of the disclosure can be designed as a normally-off device with large on-state current capability.

FIG. 6b is a vertical cross-sectional view of a second embodiment of a vertical trench-gate MOSFET according to an embodiment of the disclosure. The vertical trench-gate MOSFET in this embodiment is based on the vertical trench-gate MOSFET of the first embodiment (refer to FIG. 6a), with the adjacent region in n-type semiconductor layer 21b contacting Ohmic source electrode 12a designed as a high-resistance type semiconductor region 41; the rest of the structure remains unchanged. When the voltage V_{GS} between gate electrode 13 and source electrode 12 is greater than 0V, as V_{GS} increases, besides forming a high-concentration electron accumulation layer in the region of n-type semiconductor layer 21b adjacent to gate insulating film 51, a relatively high-concentration electron accumulation layer also forms in the region of high-resistance type semiconductor layer 41 adjacent to gate insulating film 51. At this time, when a positive voltage is applied between drain electrode 11 and source electrode 12, current will flow between drain and source. When the voltage V_{GS} between gate electrode 13 and source electrode 12 is 0V, this high-resistance doped region design cleverly blocks the conduction channel between drain electrode 11 and source electrode 12. Therefore, the MOSFET based on the solution of the disclosure is a normally-off device. Thus, the MOSFET based on the solution of the disclosure can be designed as a normally-off device with large on-state current capability.

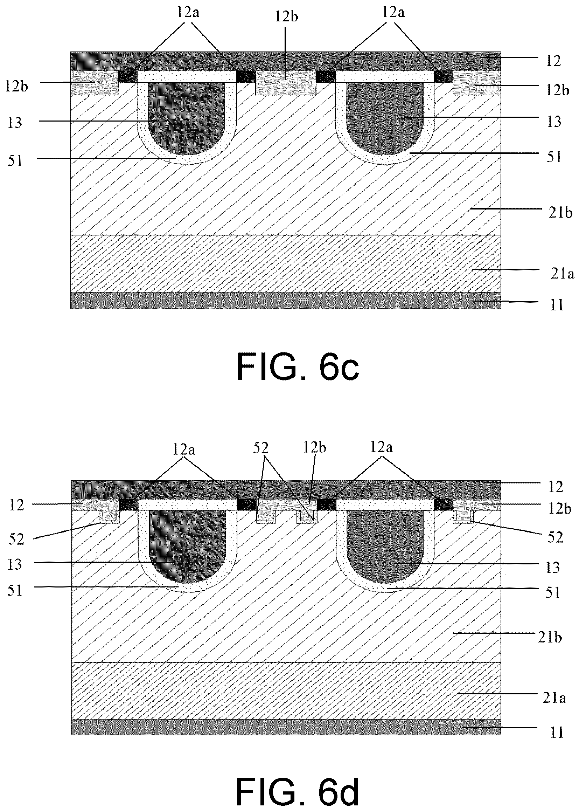

FIG. 6c is a vertical cross-sectional view of a third embodiment of a vertical trench-gate MOSFET according to an embodiment of the disclosure. The vertical trench-gate MOSFET in this embodiment is based on the vertical trench-gate MOSFET of the first embodiment (refer to FIG. 6a), with a local optimization of the structure of the Schottky contact region. Schottky source electrode 12b is designed to sink, meaning the bottom surface of Schottky source electrode 12b is lower than the bottom surface of Ohmic source electrode 12a. Through the lateral depletion effect of Schottky source electrode 12b on carriers in n-type semiconductor layer 21b on both sides, off-state leakage current can be further reduced.

FIG. 6d is a vertical cross-sectional view of a fourth embodiment of a vertical trench-gate MOSFET according to an embodiment of the disclosure. The vertical trench-gate MOSFET in this embodiment is based on the vertical trench-gate MOSFET of the first embodiment (refer to FIG. 6a), with a local optimization of the structure of the Schottky contact region. A trench is designed in the region of n-type semiconductor layer 21b forming the Schottky contact with Schottky source electrode 12b. The inner wall of the trench is covered with an insulating film layer 52 (dielectric layer). The trench is filled with a conductive material, separated from n-type semiconductor layer 21b by insulating film layer 52. The conductive material is connected to Schottky source electrode 12b. The conductive material can be the same material as Schottky source electrode 12b or a different material. In this embodiment, the conductive material uses the same material as Schottky source electrode 12b and is formed integrally with Schottky source electrode 12b. Through the design of this trench composite structure region, off-state leakage current can be reduced.

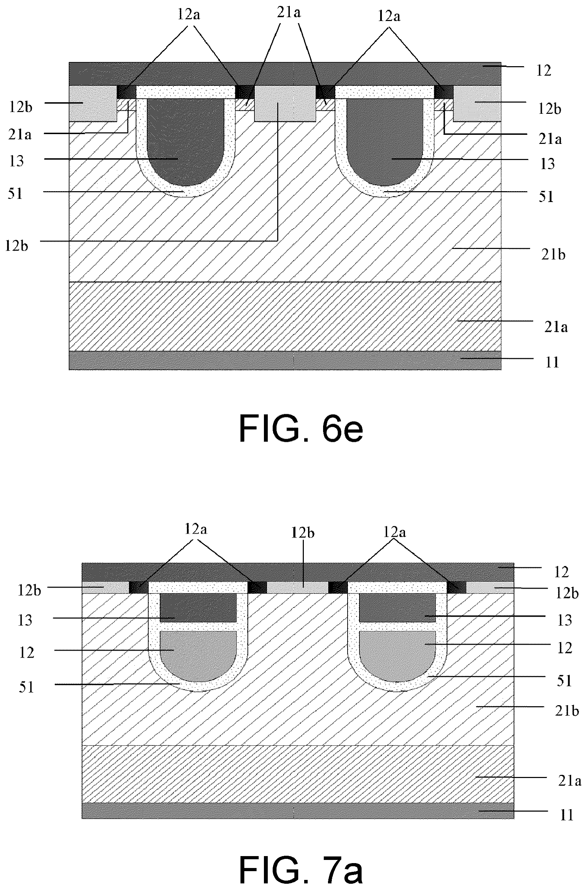

FIG. 6e is a vertical cross-sectional view of a fifth embodiment of a vertical trench-gate MOSFET according to an embodiment of the disclosure. The vertical trench-gate MOSFET in this embodiment is based on the vertical trench-gate MOSFET of the third embodiment (refer to FIG. 6c), with n-type semiconductor layer 21b contacting Ohmic source electrode 12a adjusted to n-type semiconductor layer 21a. Through this adjustment, the contact resistance between Ohmic source electrode 12a and the conductor layer can be reduced, lowering conduction loss.

FIG. 7a is a vertical cross-sectional view of a first embodiment of a vertical shielded-gate MOSFET according to an embodiment of the disclosure. The vertical shielded-gate MOSFET has, from bottom to top: drain electrode 11, n-type semiconductor layer 21a, n-type semiconductor layer 21b, a trench located in n- type semiconductor layer 21b, gate electrode 13 located in the trench and wrapped by gate insulating film 51, part of source electrode 12, Ohmic source electrode 12a forming an Ohmic contact with n-type semiconductor layer 21b, Schottky source electrode 12b forming a Schottky contact with n- type semiconductor layer 21b, and another part of source electrode 12 located thereon.

The structural design shown in FIG. 7a can also be a normally-off device with large on-state current capability. Compared to the structural design shown in FIG. 6a, the structure shown in FIG. 7a embeds part of source electrode 12 into the bottom of the trench. When the MOSFET is in the off-state, the lateral depletion effect of the embedded source electrode 12 at the trench bottom on surrounding carriers can further reduce off-state leakage current.

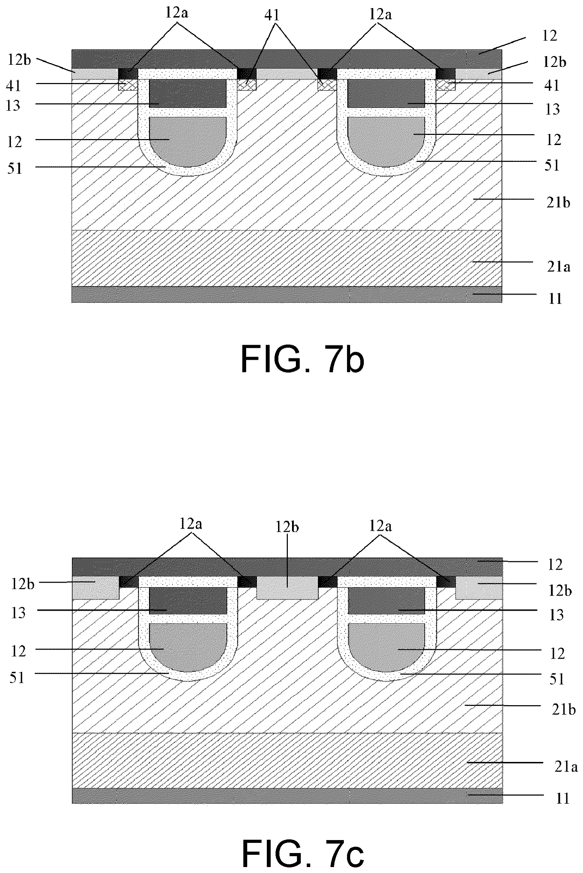

FIG. 7b is a vertical cross-sectional view of a second embodiment of a vertical shielded-gate MOSFET according to an embodiment of the disclosure. The vertical shielded-gate MOSFET in this embodiment is based on the vertical shielded-gate MOSFET of the first embodiment (refer to FIG. 7a), with the adjacent region in n-type semiconductor layer 21b contacting Ohmic source electrode 12 designed as a high-resistance type semiconductor region 41; the rest of the structure remains unchanged.

When the voltage V_{GS} between gate electrode 13 and source electrode 12 is greater than 0V, as V_{GS} increases, besides forming a high-concentration electron accumulation layer in the region of n-type semiconductor layer 21b adjacent to gate insulating film 51, a relatively high-concentration electron accumulation layer also forms in the region of high-resistance type semiconductor layer 41 adjacent to gate insulating film 51. At this time, when a positive voltage is applied between drain electrode 11 and source electrode 12, current will flow between drain and source. When the voltage V_{GS} between gate electrode 13 and source electrode 12 is 0V, this high-resistance doped region design cleverly blocks the conduction channel between drain electrode 11 and source electrode 12. Therefore, the MOSFET based on the solution of the disclosure is a normally-off device. Thus, the MOSFET based on the solution of the disclosure can be designed as a normally-off device with large on-state current capability.

FIG. 7c is a vertical cross-sectional view of a third embodiment of a vertical shielded-gate MOSFET according to an embodiment of the disclosure. The vertical shielded-gate MOSFET in this embodiment is based on the vertical shielded-gate MOSFET of the first embodiment (refer to FIG. 7a), with a local optimization of the structure of the Schottky contact region. Schottky source electrode 12b is designed to sink, meaning the bottom surface of Schottky source electrode 12b is lower than the bottom surface of Ohmic source electrode 12a. Through the lateral depletion effect of Schottky source electrode 12b on carriers in n- type semiconductor layer 21b on both sides, off-state leakage current can be further reduced.

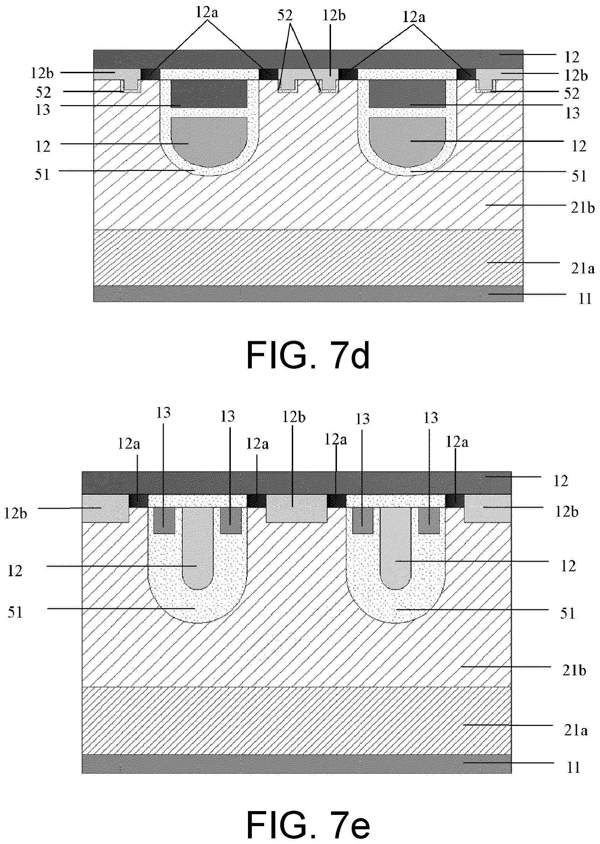

FIG. 7d is a vertical cross-sectional view of a fourth embodiment of a vertical shielded-gate MOSFET according to an embodiment of the disclosure. The vertical shielded-gate MOSFET in this embodiment is based on the vertical shielded-gate MOSFET of the first embodiment (refer to FIG. 7a), with a local optimization of the structure of the Schottky contact region. A trench is designed in the region of n- type semiconductor layer 21b forming the Schottky contact with Schottky source electrode 12b. The inner wall of the trench is covered with insulating film 52. The trench is filled with a conductive material, separated from n- type semiconductor layer 21b by insulating film 52. The conductive material is connected to Schottky source electrode 12b. The conductive material can be the same material as Schottky source electrode 12b or a different material. Through the design of this trench composite structure region, off-state leakage current can be reduced.

FIG. 7e is a vertical cross-sectional view of a fifth embodiment of a vertical shielded-gate MOSFET according to an embodiment of the disclosure. The vertical shielded-gate MOSFET in this embodiment is based on the vertical shielded-gate MOSFET of the third embodiment (refer to FIG. 7c), with a local optimization of the structure of the shielded gate region. Gate electrode 13 located in the trench is arranged on both sides of source electrode 12 in the trench, and gate electrode 13 is separated from source electrode 12 by gate insulating film 51. Compared to the vertical shielded-gate MOSFET shown in FIG. 7c, the vertical shielded-gate MOSFET in FIG. 7e, through the optimization of this region's structural design, can improve the withstand voltage performance of the MOSFET and reduce off-state leakage current.

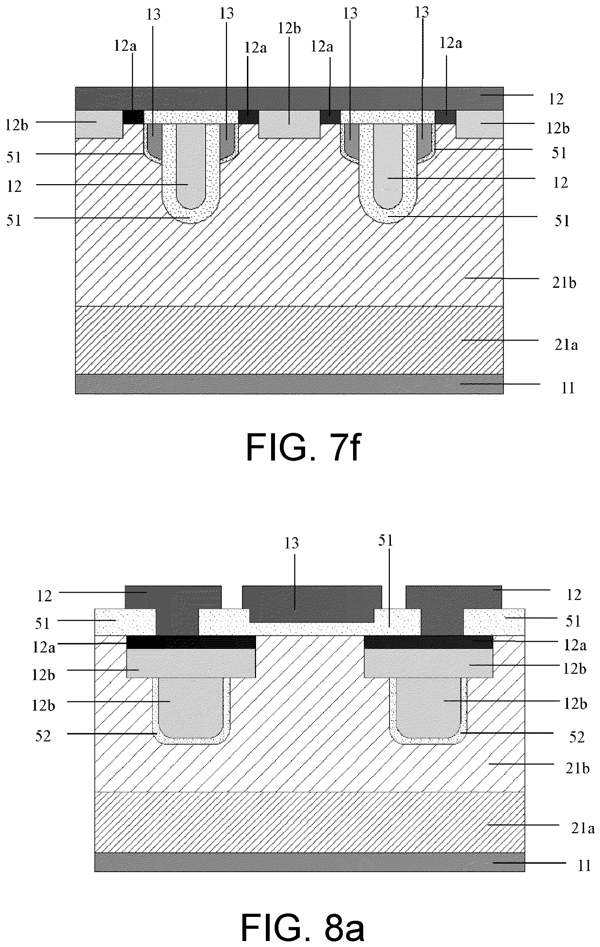

FIG. 7f is a vertical cross-sectional view of a sixth embodiment of a vertical shielded-gate MOSFET according to an embodiment of the disclosure. The vertical shielded-gate MOSFET in this embodiment is based on the vertical shielded-gate MOSFET of the third embodiment (refer to FIG. 7c), with a local optimization of the structure of the shielded gate region. Gate electrode 13 located in the trench is arranged on both sides of source electrode 12 in the trench, and gate electrode 13 is separated from source electrode 12 by gate insulating film 51. Compared to the vertical shielded-gate MOSFET shown in FIG. 7c, the vertical shielded-gate MOSFET in FIG. 7f, through the optimization of this region's structural design, can improve the withstand voltage performance of the MOSFET and reduce off-state leakage current.

FIG. 8a is a vertical cross-sectional view of a first embodiment of a vertical super-junction MOSFET according to an embodiment of the disclosure. The vertical super-junction MOSFET structure shown in FIG. 8a is based on the vertical planar-gate MOSFET shown in FIG. 5a, with a trench provided in the region of n-type semiconductor layer 21b below and adjacent to Schottky source electrode 12b. The inner wall of the trench is covered with an insulating film layer 52. The trench is filled with a conductive material, separated from n-type semiconductor layer 21b by insulating film layer 52. The conductive material is connected to Schottky source electrode 12b. In the super-junction MOSFET shown in FIG. 8a, by adding a super-junction structure below Schottky source electrode 12b, when the MOSFET is in the off-state, the lateral depletion effect of the super-junction structure on electron carriers in n-type semiconductor layer 21b can reduce high-voltage leakage current and further improve withstand voltage capability.

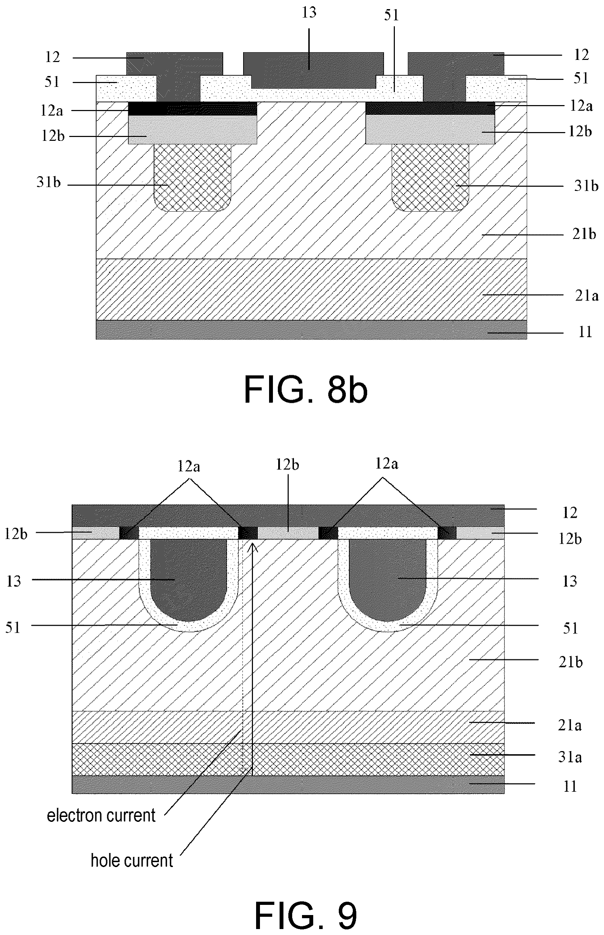

FIG. 8b is a vertical cross-sectional view of a second embodiment of a vertical super-junction MOSFET according to an embodiment of the disclosure. The super-junction MOSFET structure shown in FIG. 8b fills the trench in n-type semiconductor layer 21b with p-type conductive material, which can form a pn junction with n-type semiconductor layer 21b. When the MOSFET is in the off-state, the lateral depletion effect of the super-junction structure on electron carriers in n-type semiconductor layer 21b can reduce high-voltage leakage current and further improve withstand voltage capability.

FIG. 9 is a vertical cross-sectional view of an embodiment of an insulated gate bipolar transistor (IGBT) according to an embodiment of the disclosure. It is equivalent to adding a p-type semiconductor layer 31a between n-type semiconductor layer 21a and drain electrode 11 based on one of the MOSFET structures of the disclosure (FIG. 6a), forming an insulated gate bipolar transistor. In the insulated gate bipolar transistor shown in FIG. 9, when a voltage V_{GS} is applied between gate electrode 13 and source electrode 12, as V_{GS} increases, a complete and high-concentration electron channel is formed in the region of n-type semiconductor layer 21b adjacent to the right side of gate insulating film 51. Outside the electron channel formed in the region of n-type semiconductor layer 21b adjacent to the right side of gate insulating film 51, a certain concentration hole accumulation region will form. At this time, when a certain positive voltage V_{GS} is applied between drain electrode 11 and source electrode 12, current will flow between drain and source. This current consists of two parts: one part is the electron current flowing from Ohmic source electrode 12a all the way to drain electrode 11, and the other part is the hole current flowing from drain electrode 11 to Ohmic source electrode 12a. This insulated gate bipolar transistor has a larger current-carrying capability than the MOSFET described in the disclosure.

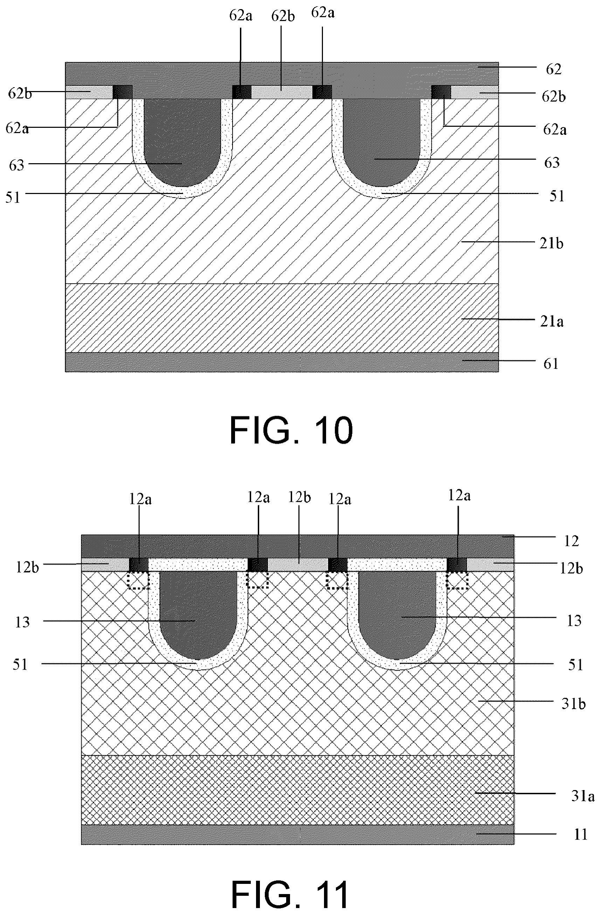

FIG. 10 is a vertical cross-sectional view of an embodiment of a trench MOS-type diode according to an embodiment of the disclosure. The trench MOS-type diode includes: cathode electrode 61, anode electrode 62, n-type semiconductor layer 21a (first n-type semiconductor layer), n-type semiconductor layer 21b (second n-type semiconductor layer), a trench located in n-type semiconductor layer 21b, and a trench MOS gate electrode 63 disposed within the trench and wrapped by gate insulating film 51. The trench opens from the surface of n-type semiconductor layer 21b opposite to n-type semiconductor layer 21a. Cathode electrode 61 is formed on the surface of n-type semiconductor layer 21a opposite to n-type semiconductor layer 21b. Anode electrode 62 is formed on the surface of n- type semiconductor layer 21b opposite to n+ type semiconductor layer 21a. Anode electrode 62 has a first portion 62b and a second portion 62a. The first portion 62b of anode electrode 62 contacts n-type semiconductor layer 21b forming a Schottky barrier contact, defined as Schottky anode 62b. The second portion 62a of anode electrode 62 contacts n-type semiconductor layer 21b forming an Ohmic contact, defined as Ohmic anode 62a.

In the trench MOS-type diode shown in FIG. 10, when a forward voltage is applied between anode electrode 62 and cathode electrode 61, current flows between anode and cathode, and the diode conducts forward. There are two current paths: The first current path is along anode electrode 62 - Ohmic anode 62a - region adjacent to gate insulating film 51 in n-type semiconductor layer 21b - n-type semiconductor layer 21a - cathode electrode 61. The second current path is along anode electrode 62 - Schottky anode 62b - n-type semiconductor layer 21b - n-type semiconductor layer 21a - cathode electrode 61. In the first current path, there is no contact barrier between Ohmic anode 62a and n-type semiconductor layer 21b. In the second current path, there is a Schottky barrier between Schottky anode 62b and n-type semiconductor layer 21b. During forward conduction of the diode, since the hindrance of the first current path is relatively small, the turn-on voltage required is lower than that of the second current path. Therefore, current preferentially flows through the first current path. Compared to traditional trench MOS-type Schottky diodes, it is clear that the trench MOS-type diode based on the disclosure, due to its lower turn-on voltage, has lower conduction loss.

In the trench MOS-type diode shown in FIG. 10, when a reverse voltage is applied between anode electrode 62 and cathode electrode 61, two types of electron carrier depletion occur: The first type is the reverse bias of the Schottky barrier formed by Schottky anode 62b and n-type semiconductor layer 21b, generating longitudinal depletion of electron carriers in n-type semiconductor layer 21b. The second type is the MIS (Metal-Insulator-Semiconductor) junction constituted by trench MOS gate electrode 63, gate insulating film 51, and n-type semiconductor layer 21b, generating lateral depletion of electron carriers in n-type semiconductor layer 21b. Under the combined action of the longitudinal depletion formed by the reverse-biased Schottky barrier and the lateral depletion formed by the MIS structure, the electron carriers in n-type semiconductor layer 21b between the trenches are depleted. Only a very small leakage current flows between anode electrode 62 and cathode electrode 61, and the diode is reverse-blocking.

In the trench MOS-type diode shown in FIG. 10, an insulating layer can also be added between anode electrode 62 and trench MOS gate electrode 63, so that trench gate electrode 63 and anode electrode 62 are not in direct contact. During packaging applications, using mature wire bonding processes, trench gate electrode 63 and anode electrode 62 can be electrically connected externally to the chip. Designed this way, the trench MOS-type diode can still function.

FIG. 11 is a vertical cross-sectional view of an embodiment of a vertical trench MOSFET related to a p-type semiconductor layer according to an embodiment of the disclosure. The vertical trench MOSFET has, from bottom to top: drain electrode 11, p-type semiconductor layer 31a, p-type semiconductor layer 31b stacked thereon, a trench located in p-type semiconductor layer 31b, filled with gate electrode 13 and gate insulating film 51 interposed between gate electrode 13 and p-type semiconductor layer 31b, Ohmic source electrode 12a and Schottky source electrode 12b located on the upper surface of p-type semiconductor layer 31b, and source electrode 12c located on top. Ohmic source electrode 12a contacts p-type semiconductor layer 31b forming an Ohmic contact. Schottky source electrode 12b contacts p-type semiconductor layer 31b forming a Schottky contact. In the MOSFET shown in FIG. 11, when a negative voltage is applied between gate electrode 13 and source electrode 12, a high-concentration hole carrier accumulation layer is formed in the region of p-type semiconductor layer 31b adjacent to gate insulating film 51. At this time, a complete and high-concentration hole channel is formed between source electrode 12 and drain electrode 11. When a positive voltage is applied between source electrode 12 and drain electrode 11 at this time, current will flow between source and drain. When the voltage V_{GS} between gate electrode 13 and source electrode 12 is 0V, due to the combined depletion effect on hole carriers in p-type semiconductor layer 31b by the MIS junction located on the left and right sides of Ohmic source electrode 12a and the Schottky junction located beside it, the corner region of p-type semiconductor layer 31b that is both adjacent to gate insulating film 51 and simultaneously adjacent to Ohmic source electrode 12a (position circled by the dashed line in FIG. 11) becomes a depletion region for hole carriers. This depletion region blocks the hole conduction channel between drain electrode 11 and source electrode 12. At this time, even when a positive voltage is applied between source electrode 12 and drain electrode 11, only a small leakage current flows between source and drain, the MOSFET is in the off-state. Therefore, the MOSFET based on the solution of the disclosure is a normally-off device. Thus, the MOSFET based on the solution of the disclosure can be designed as a normally-off device with large on-state current capability.

n-type semiconductors and Schottky source-drain electrodes can constitute Schottky source-drain MOSFETs (n-type Schottky source-drain MOSFETs). p-type semiconductors and Schottky source-drain electrodes can also constitute Schottky source-drain MOSFETs (p-type Schottky source-drain MOSFETs). Whether n-type or p-type Schottky source-drain MOSFETs, both suffer from the problem of small on-state current. The embodiments shown in FIGS. 5a to 8b demonstrate that when the design concept of the disclosure is combined with an n-type semiconductor, an n-channel MOSFET with large on-state current capability can be fabricated, completely solving the problem of small on-state current in n-type Schottky source-drain MOSFETs, and its on-state current capability can match that of an n-channel pn-junction MOSFET. Similarly, when the design concept of the disclosure is combined with a p-type semiconductor, a p-channel MOSFET with large on-state current capability can also be fabricated, completely solving the problem of small on-state current in p-type Schottky source-drain MOSFETs, and its on-state current capability can match that of a p-channel pn-junction MOSFET.

Spatially relative terms used herein, such as "upper", "lower", "upper part", "above", "lower part", etc., are used to conveniently describe the relationship of one element or feature shown in the figure to another element or feature. It will be understood that the spatially relative terms are intended to encompass different orientations of the device in use in addition to the orientation depicted in the drawings. For example, if the device in the figure is inverted, elements described as "below" or "beneath" other elements or features would then be oriented "above" the other elements or features. Thus, the term "below" can encompass both below and above orientations. The device may also be oriented differently (rotated 90 degrees or at other orientations), and the spatially relative descriptors used herein interpreted accordingly.

It should be understood that the above embodiments are only used to illustrate the technical solutions of the disclosure and are not intended to limit it. Although the disclosure has been described in detail with reference to the foregoing embodiments, those of ordinary skill in the art should understand that they can still modify the technical solutions described in the foregoing embodiments or equivalently replace some of the technical features; these modifications or replacements do not cause the essence of the corresponding technical solutions to depart from the spirit and scope of the technical solutions of the embodiments of the disclosure, and should be included within the protection scope of the disclosure.

## Claims

1. A field-effect transistor, comprising:
an n-type semiconductor layer;
electrodes including a drain electrode, a source electrode, and a gate electrode;
a gate insulating film interposed between the gate electrode and the n-type semiconductor layer;
**characterized in that**: a Schottky barrier exists between a first portion of the source electrode and the n-type semiconductor layer, a second portion of the source electrode contacts the n-type semiconductor layer to form an ohmic contact; and the second portion of the source electrode is closer to the gate insulating film than the first portion of the source electrode.

2. The field-effect transistor according to claim 1, **characterized in that** the first portion of the source electrode contacts the n-type semiconductor layer to form the Schottky barrier.

3. The field-effect transistor according to claim 1, **characterized in that** no dielectric layer exists between the first portion of the source electrode and the n-type semiconductor layer, and the first portion of the source electrode, the dielectric layer, and the n-type semiconductor layer together form a metal-insulator-semiconductor junction.

4. The field-effect transistor according to claim 1, **characterized in that** the second portion of the source electrode is located between the first portion of the source electrode and the gate insulating film.

5. The field-effect transistor according to claim 1, **characterized in that** a work function of a material corresponding to the second portion of the source electrode is lower than a work function of a material corresponding to the n-type semiconductor layer.

6. The field-effect transistor according to claim 1, **characterized in that** a width range from an end of the second portion of the source electrode distal to the gate insulating film to the gate insulating film is between 3nm and 200nm.

7. The field-effect transistor according to claim 1, **characterized in that** a width range from an end of the second portion of the source electrode distal to the gate insulating film to the gate insulating film is between 3nm and 100nm.

8. The field-effect transistor according to claim 1, **characterized in that** the second portion of the source electrode and the first portion of the source electrode are metals or alloys having different work functions.

9. The field-effect transistor according to claim 1 or 2, **characterized in that** the first portion of the source electrode and the second portion of the source electrode are coplanar.

10. The field-effect transistor according to claim 1 or 2, **characterized in that** a bottom surface of the first portion of the source electrode is lower than a bottom surface of the second portion of the source electrode.

11. The field-effect transistor according to claim 1 or 2, **characterized in that** the n-type semiconductor layer comprises multiple semiconductor layers, each of the semiconductor layers having a different donor concentration.

12. The field-effect transistor according to claim 1 or 2, **characterized in that** a donor concentration of a region of the n-type semiconductor layer contacting the second portion of the source electrode to form the ohmic contact is ≥ 1.0×1018 cm⁻³.

13. The field-effect transistor according to claim 2, **characterized in that** a region of the n-type semiconductor layer contacting the first portion of the source electrode to form the Schottky contact has a groove, an inner wall of the groove is covered with an insulating film layer, the groove is filled with a conductive material, and the conductive material is separated from the n-type semiconductor layer by the insulating film layer.

14. The field-effect transistor according to claim 1 or 2, **characterized in that** a region of the n-type semiconductor layer contacting the first portion of the source electrode to form the Schottky contact has a plurality of mutually spaced p-type regions formed by ion implantation, and the p-type regions form pn junctions with the n-type semiconductor layer.

15. The field-effect transistor according to claim 1, **characterized in that** the field-effect transistor is a lateral MOSFET or a vertical MOSFET.

16. The field-effect transistor according to claim 15, **characterized in that** the vertical MOSFET is a vertical planar gate MOSFET, a vertical trench gate MOSFET, a vertical shielded gate MOSFET, or a vertical super-junction MOSFET.

17. The field-effect transistor according to claim 1, **characterized in that** the n-type semiconductor layer is composed of an oxide-based semiconductor, a compound semiconductor, or an elemental semiconductor.

18. A field-effect transistor, comprising:
a semiconductor layer containing an n-type conductive region and a high-resistance doped region;
electrodes including a drain electrode, a source electrode, and a gate electrode;
a gate insulating film interposed between the gate electrode and the n-type conductive region;
**characterized in that**: a Schottky barrier exists between a first portion of the source electrode and the n-type conductive region of the semiconductor layer, a second portion of the source electrode contacts the high-resistance doped region of the semiconductor layer; and the second portion of the source electrode is closer to the gate insulating film than the first portion of the source electrode.

19. The field-effect transistor according to claim 18, **characterized in that** the first portion of the source electrode contacts the n-type conductive region of the semiconductor layer to form the Schottky barrier.

20. The field-effect transistor according to claim 18, **characterized in that** a dielectric layer is further provided between the first portion of the source electrode and the n-type conductive region of the semiconductor layer, and the first portion of the source electrode, the dielectric layer, and the n-type conductive region together form a metal-insulator-semiconductor junction.

21. The field-effect transistor according to claim 18, **characterized in that** the second portion of the source electrode is located between the first portion of the source electrode and the gate insulating film.

22. The field-effect transistor according to claim 18, **characterized in that** a work function of a material corresponding to the second portion of the source electrode is lower than a work function of a material corresponding to the semiconductor layer.

23. The field-effect transistor according to claim 18, **characterized in that** the second portion of the source electrode and the first portion of the source electrode are metals or alloys having different work functions.

24. The field-effect transistor according to claim 18, **characterized in that** the n-type conductive region of the semiconductor layer contacting the first portion of the source electrode to form the Schottky contact has a groove, an inner wall of the groove is covered with an insulating film layer, the groove is filled with a conductive material, and the conductive material is separated from the n-type semiconductor layer by the insulating film layer.

25. The field-effect transistor according to claim 18, **characterized in that** the n-type conductive region of the semiconductor layer contacting the first portion of the source electrode to form the Schottky contact has a plurality of mutually spaced p-type regions formed by ion implantation, and the p-type regions form pn junctions with the n-type conductive region.

26. The field-effect transistor according to claim 18, **characterized in that** the field-effect transistor is a lateral MOSFET or a vertical MOSFET.

27. The field-effect transistor according to claim 26, **characterized in that** the vertical MOSFET is a vertical planar gate MOSFET, a vertical trench gate MOSFET, a vertical shielded gate MOSFET, or a vertical super-junction MOSFET.

28. A field-effect transistor, comprising:
a p-type semiconductor layer;
electrodes including a drain electrode, a source electrode, and a gate electrode;
a gate insulating film interposed between the gate electrode and the p-type semiconductor layer;
**characterized in that**: a Schottky barrier exists between a first portion of the source electrode and the p-type semiconductor layer, a second portion of the source electrode contacts the p-type semiconductor layer to form an ohmic contact; and the second portion of the source electrode is closer to the gate insulating film than the first portion of the source electrode.

29. The field-effect transistor according to claim 28, **characterized in that** the first portion of the source electrode contacts the p-type semiconductor layer to form the Schottky barrier.

30. The field-effect transistor according to claim 28, **characterized in that** no dielectric layer exists between the first portion of the source electrode and the p-type semiconductor layer, and the first portion of the source electrode, the dielectric layer, and the p-type semiconductor layer together form a metal-insulator-semiconductor junction.

31. An insulated gate bipolar transistor, comprising:
a semiconductor layer including a p-type semiconductor layer and an n-type semiconductor layer stacked on the p-type semiconductor layer;
electrodes including a collector electrode, an emitter electrode, and a gate electrode;
a gate insulating film interposed between the gate electrode and the n-type semiconductor layer;
**characterized in that**: a Schottky barrier exists between a first portion of the emitter electrode and the n-type semiconductor layer, a second portion of the emitter electrode contacts the n-type semiconductor layer to form an ohmic contact; and the second portion of the emitter electrode is closer to the gate insulating film than the first portion of the emitter electrode.

32. The insulated gate bipolar transistor according to claim 31, **characterized in that** the second portion of the emitter electrode is located between the first portion of the emitter electrode and the gate insulating film.

33. The insulated gate bipolar transistor according to claim 31, **characterized in that** the first portion of the emitter electrode contacts the n-type semiconductor layer to form the Schottky barrier.

34. A trench MOS diode, comprising:
a semiconductor layer including a first n-type semiconductor layer and a second n-type semiconductor layer, the second n-type semiconductor layer stacked on the first n-type semiconductor layer, the second n-type semiconductor layer having a trench, the trench opening from a surface of the second n-type semiconductor layer opposite to the first n-type semiconductor layer, a donor concentration of the second n-type semiconductor layer being less than a donor concentration of the first n-type semiconductor layer;
an anode electrode formed on the surface of the second n-type semiconductor layer opposite to the first n-type semiconductor layer;
a cathode electrode formed on a surface of the first n-type semiconductor layer opposite to the second n-type semiconductor layer;
a trench MOS gate electrode embedded in the trench of the second n-type semiconductor layer, separated from the semiconductor layer by an insulating film;
**characterized in that**: a first portion of the anode electrode contacts the second n-type semiconductor layer to form a Schottky contact, a second portion of the anode electrode contacts the second n-type semiconductor layer to form an ohmic contact, and the second portion of the anode electrode is closer to the insulating film than the first portion of the anode electrode.

35. The trench MOS diode according to claim 34, **characterized in that** a work function of a material corresponding to the second portion of the anode electrode is lower than a work function of a material corresponding to the second n-type semiconductor layer.

36. The trench MOS diode according to claim 34, **characterized in that** a width range from an end of the second portion of the anode electrode distal to the insulating film to the insulating film is between 3nm and 200nm.

37. The trench MOS diode according to claim 34, **characterized in that** a width range from an end of the second portion of the anode electrode distal to the insulating film to the insulating film is between 3nm and 150nm.

38. The trench MOS diode according to claim 34, **characterized in that** the trench MOS gate electrode directly contacts the anode electrode, or the trench MOS gate electrode is separated from the anode electrode by an insulating layer.
